Europäisches Patentamt

European Patent Office

Office européen des brevets

(19)

(11) EP 0 785 295 B1

(12) EUROPEAN PATENT SPECIFICATION

(45) Date of publication and mention
of the grant of the patent:
**09.07.2003 Bulletin 2003/28**

(51) Int Cl.7: **C25D 1/04**, H05K 3/38

(21) Application number: **97100241.5**

(22) Date of filing: **09.01.1997**

(54) **Electrolytic copper foil for printed wiring board and method for manufacturing the same**

Elektrolytische Kupferfolie für eine gedruckte Schaltungsplatte und verfahren zu ihrer Herstellung

Feuille de cuivre électrolytique pour circuit imprimé et son procédé de fabrication

(84) Designated Contracting States:
**DE FR GB IT LU SE**

(30) Priority: **16.01.1996 JP 2161896**

(43) Date of publication of application:
**23.07.1997 Bulletin 1997/30**

(73) Proprietor: **MITSUI MINING & SMELTING CO., LTD.**
**Chuo-ku, Tokyo (JP)**

(72) Inventors:
 • **Tagusari, Hideyasu**
 **Itabashi-ku, Tokyo (JP)**
 • **Hirasawa, Yutaka**
 **Okegawa-shi, Saitama (JP)**
 • **Oshima, Kazuhide**
 **Ageo-shi, Saitama (JP)**

(74) Representative: **Modiano, Guido, Dr.-Ing. et al**
 **Modiano, Josif, Pisanty & Staub,**
 **Baaderstrasse 3**
 **80469 München (DE)**

(56) References cited:
**US-A- 5 215 646**

 • **DATABASE WPI Section Ch, Week 9441 Derwent Publications Ltd., London, GB; Class A35, AN 94-327968 XP002030002 & JP 06 252 548 A (FURUKAWA ELECTRIC CO LTD) , 9 September 1994**

**Description**

FIELD OF THE INVENTION

This invention relates to an electrolytic copper foil for use in the manufacture of a printed wiring board and also to a method for manufacturing the electrolytic copper foil. In particular, this invention related to an electrolytic copper foil provided with a fine granular electrodeposit which is uniformly and densely formed on a surface of a matte or rough side of the electrolytic copper foil, said surface being treated in advance with buffing. The electrolytic copper foil formed in this manner is excellent in etching properties at the occasion of forming a wiring pattern and hence quite suited for use in the formation of an ultra-fine pattern which is excellent in high-frequency characteristic and in insulation reliability.

**BACKGROUND OF THE INVENTION**

The electrolytic copper foil to be employed in the manufacture of a printed wiring board is generally obtained by first electrodepositing copper on the surface of a cathode drum by an electrochemical means, i.e. by the electrolysis of a copper electrolyte, and then by stripping the resultant electrodeposited copper layer from the cathode drum. The electrolytic copper foil obtained in this manner is also called an electrodeposited copper foil. A shiny or glossy (drum) side of this electrodeposited copper foil is relatively smooth, but a matte or rough (copper depositing front side thereof is generally rugged. The copper-clad laminated board to be employed in the manufacture of a printed wiring board is manufactured by forming a granular copper electrodeposit on the matte side of this electrodeposited copper foil (a nodular forming treatment), superimposing the foil on a resin substrate made of fiberglass epoxy composite or polyimide facing this treated matte side to the substrate with heat and pressure applied. The wiring pattern of the printed wiring board is formed by etching this copper-clad laminated board.

However, in recent trend of adopting an ultra-fine pattern of a printed wiring board, the magnitude of ruggedness or irregularity of the matte side of the copper foil has raised a problem that the ruggedness of the matte side of the copper foil is relatively large as compared with the fineness of a wiring pattern which is desired to be formed on the printed wiring board, thereby inviting a deterioration in insulation reliability between circuit lines or between circuit layers.

In order to overcome this problem, there has been recently tried to employ a very low profile foil (VLP foil), i. e. an electrodeposited copper foil whose matte side surface's roughness is controlled to a low degree. According to JIS B 0601, an ordinary electrodeposited copper foil having a thickness of 18μm has a surface roughness (Rz) of 5 to 8μm at its matte side wherein Rz is the average deviation from the mean line of the five highest peaks and five lowest valleys within the roughness sampling length. Whereas, in the case of the VLP foil, the Rz thereof is about 3 to 5μm. On the other hand, the Rz of the shiny side (a drum side) of this electrodeposited copper foil, which is opposite to the matte side, is about 1.5 to 2.0μm irrespective of the kinds of the electrodeposited copper foil since this shiny side is constituted by a transfer surface from the surface of drum.

Even if the surface roughness of the VLP foil is relatively low, some degree of roughness is still remained in the surface of the VLP foil, thus raising a problem in the occasion of the aforementioned nodular forming treatment that the nodules to be formed in the treatment are concentrated at the tops of convex portions. If the nodules are concentrated in this manner, they may become copper remnants embedded in the substrate after the formation of a fine pattern so that an extra-etching for removing these copper remnants may be required to be carried out. If this extra-etching is performed, the fine pattern may be over-etched, thus raising a problem that the line width of the pattern may become narrower than a predetermined width.

There is also proposed a method for forming a fine pattern (Japanese Patent Application Laid-Open Gazette No. Hei 6-270,331) wherein the aforementioned nodular forming treatment is conducted on the shiny side of an electrodeposited copper foil, and then a substrate is superimposed on this shiny side of an electrodeposited copper foil thereby manufacturing a copper-clad laminated board for forming a fine pattern.

According to the method of this Japanese Patent Application Laid-Open Gazette No. Hei 6-270,331, however, it is difficult to uniformly electrodeposit copper granules on the shiny side of an electrodeposited copper foil in the nodular forming treatment. Namely, although the surface roughness after the nodular forming treatment of the foil is as low as 2.0 to 2.2 in Rz, a nodule of relatively large size is locally formed, thereby making it difficult to employ such a foil for use in the formation of an ultra-fine pattern.

There is also proposed a method wherein the aforementioned nodular forming treatment is conducted after an electrodeposited copper foil is roll-worked in such a degree that an original profile on a matte surface would not be completely vanished (Japanese Patent Application Laid-Open Gazette No. Sho 62-42,022). Furthermore, there is also proposed a method wherein the aforementioned nodular forming treatment is conducted after an electrodeposited copper foil is subjected to a grinding, a planing, a discharge-working or an electrolytic polishing in such a degree that the original profile on a matte surface would not be completely vanished (Japanese Patent Application Laid-Open Gazette No. Sho 59-145,800).

However, in any of these methods of nodular forming method according to the prior art, the original rugged surface of the copper foil is still left remained partially, so that it is difficult to carry out a uniform formation of minute nodules, i.e. it is impossible to avoid a local electrodeposition of the nodules, thus failing to reduce the roughness of the original matte surface of the foil to any substantial degree. In other words, it has been impossible according to the prior art to obtain an electrolytic copper foil which is excellent in etching properties at the occasion of forming a wiring pattern and suited for use in the formation of an ultra-fine pattern which is excellent in high-frequency characteristic and in insulation reliability.

## Summary of the Invention

The present invention has been made in view of solving the aforementioned problems involved in the prior art, and therefore an object of the present invention is to provide an electrolytic copper foil which is excellent in adhesivity with a substrate and in etching properties at the occasion of forming a wiring pattern and suited for use in the formation of an ultra-fine pattern excellent in high-frequency characteristic and in insulation reliability.

Another object of this invention is to provide a method of forming such an excellent electrolytic copper foil.

It has been found by the present inventors after intensive studies on the aforementioned problems involved in the prior art that it is possible to solve these problems by buffing at first a matte side of an electrolytic copper foil so as to completely extinguish the original profile of the matte surface and at the same time to form a new fine rugged surface having a surface roughness (Rz) of 1.5μm or less, and then by uniformly forming nodules on this new fine rugged surface (a nodular forming treatment) thereby obtaining the electrolytic copper foil having a surface roughness (Rz) of 1.5 to 2.0μm. According to this process, it is possible to obtain an electrolytic copper foil for a print wiring board, which is excellent in adhesivity with a substrate and in etching properties at the occasion of forming a wiring pattern and suited for use in the formation of an ultra-fine pattern excellent in high-frequency characteristic and in insulation reliability. This invention has been accomplished based on these findings.

Namely, according to the present invention, there is provided an-electrolytic copper foil in which an original profile of a matte surface thereof has been completely extinguished and fine ruggednesses having buffed streaks have been newly formed thereon, characterized in that a surface roughness (Rz) of the matte surface before forming a nodular layer is 1.5μm or less and the Rz thereof after forming said nodular layer is 1.5 to 2.0μm.

## Brief Description of the Drawing

FIG. 1 is a microscopic photograph showing a surface of an electrolytic copper foil provided thereon with a granular copper layer according to Example 1;

FIG. 2 is a microscopic photograph showing a cross-sectional view in the longitudinal direction of a wiring pattern portion;

FIG. 3 is a schematic cross-sectional view in the longitudinal direction of a wiring pattern portion for illustrating a method for calculating an average value and standard deviation of copper grains, depth embedded in the substrate;

FIG. 4 is a schematic cross-sectional view of a wiring pattern for illustrating a method for calculating an etching factor Ef;

FIG. 5 is an electron-microscopic photograph showing a treated surface of an electrolytic copper foil obtained according to Example 1;

FIG. 6 is a schematic plan view of a wiring pattern for illustrating a method for calculating the linearity of a circuit;

FIG. 7 is a microscopic photograph showing a surface of an electrolytic copper foil provided thereon with a granular copper layer according to Comparative Example 1;

FIG. 8 is an electron-microscopic photograph showing a treated surface of an electrolytic copper foil obtained according to Comparative Example 1;

FIG. 9 is a microscopic photograph showing a surface of an electrolytic copper foil provided thereon with a granular copper layer according to Comparative Example 1; and

FIG. 10 is an electron-microscopic photograph showing a treated surface of an electrolytic copper foil obtained according to Comparative Example 2.

## Description of the Preferred Embodiment

This invention will be explained in detail as follows.

As for the copper foil to be employed in this invention, an ordinary copper foil whose matte surface side is relatively high in roughness as well as a very low profile foil (VLP copper foil) whose matte surface is very low in roughness can be employed. In the following explanation however, the embodiments where the VLP copper foil was employed will be explained.

The electrolytic copper foil for use in a printed wiring board according to this invention is featured in that the matte side (copper deposit growth front) of an original electrolytic copper foil is subjected in advance to a buffing treatment to form a surface of 1.5μm or less in roughness, and then this buffed surface is subjected to a nodular forming treatment to obtain a surface roughness Rz of 1.5 to 2.0μm after said nodular surface-forming treatment.

If the roughness of the matte side of electrolytic copper foil after the buffing treatment is more than 1.5μm, the copper electrodeposit is more likely to be undesirably concentrated at the top portion of convex portions of the buffed surface at the occasion of forming a granular copper electrodeposit on the buffed surface of the electrolytic copper foil (a nodular forming treatment).

Meanwhile, if the surface roughness of the matte side of the electrolytic copper foil after the formation of granular copper electrodeposit thereon is less than 1.5μm, the peel strength of a wiring pattern after the formation thereof on a printed wiring board would be insufficient. On the other hand, if the surface roughness of the matte surface side of the electrolytic copper foil after the formation of granular copper electrodeposit thereon exceeds over 2.0μm, a relatively large nodule may be locally grown, thus deteriorating the etching property, high-frequency characteristic and insulation reliability of the resultant electrolytic copper foil.

By the term, "nodular forming treatment" as recited in this invention, it is meant a treatment for forming a minute granular copper electrodeposit on the matte side of an electrolytic copper foil by making use of an electrolytic solution, thereby improving an anchoring effect of the adhering surface of the electrolytic copper foil to a substrate to be adhered thereon.

This invention will be further explained in detail with respect to the method for manufacturing an electrolytic copper foil for use in a printed wiring board according to this invention.

The method for manufacturing an electrolytic copper foil according to this invention is featured in that the method comprises the steps of buffing a matte surface of the electrolytic copper foil to completely extinguish an original profile of the matte surface, further buffing the completely extinguished matte surface to newly form fine ruggednesses having buffed streaks and to controll a surface roughness of the matte surface before forming nodules thereon to 1.5μm or less, and subjecting said matte surface to a nodular forming treatment to control the surface roughness to 1.5 to 2.0μm after said nodular forming treatment.

According to a method for manufacturing an electrolytic copper foil of this invention, first of all, an electrodeposited copper foil is passed through a guide roll and at the same time, the matte side of the foil is pressed onto a buff so as to completely vanish the original profile of the matte surface and to form a new minute rugged surface having a roughness Rz of 1.5μm or less. The number of revolution of the buff in this case should preferably be 100 to 1,000 rpm. If the number of revolution of the buff is less than 100 rpm, it is difficult to form a uniform surface roughness. On the other hand, if the number of revolution of the buff is more than 1,000 rpm, the rotation of the buff becomes unstable. In any case, if the number of revolution of the buff falls outside the aforementioned range, it would be difficult to stably obtain an electrolytic copper foil having a surface roughness Rz of 1.5μm or less.

The contacting pressure of the buff should preferably be 0.5 to 3.0 kgf/cm$^2$, more preferably 1.0 to 2.0 kgf/cm$^2$. If the contact pressure of the buff is less than 0.5 kgf/cm$^2$, the pressure would be too weak to sufficiently reduce the surface roughness to a desired extent. On the other hand, if the contact pressure of the buff is more than 3.0 kgf/cm$^2$, the pressure to the copper foil becomes so strong that it will badly affect the physical strength of the copper foil, occasionally causing the fracture of the copper foil.

The buffing should preferably be performed at a line speed in the range of from 2 to 4 m/min. If the buffing is performed at a line speed falling outside this range, the polishing may become non-uniform, making it difficult to obtain an electrolytic copper foil having a surface roughness of 1.5μm or less.

As for the kind of abrasive material to be employed in this buffing, there is no limitation. However, the grain diameter of the abrasive material should preferably be confined to 5 to 50μm. For example, it may be preferable to perform the buffing using a buff of #1,000 wherein aluminum oxide is employed as an abrasive material. By means of this buffing, the surface roughness of the rough side of the electrolytic copper foil is controlled to 1.5μm or less based on Rz. With this buffing, the original ruggedness on the matte surface of the copper foil which has been generated as a result of electrolysis is removed (completely vanishing the original rugged shape), and at the same time new very fine streaks are densely formed on this matte surface of the copper foil thereby forming a matte surface having a predetermined roughness.

Subsequently, a nodular forming treatment is performed on this buffed matte side having a roughness Rz of 1.5μm or less. In this nodular forming treatment, the top portions of the convex portions of the matte surface are electrodeposited with nodular copper grains generally in preference to other portions of the matte surface. Accordingly, since the number of the top portions per unit area is large on this matte surface of the copper foil as a result of the aforementioned buffing treatment of densely forming new very fine streaks on the surface, the copper grains can be uniformly and densely electrodeposited on this matte surface. This nodular forming treatment is performed by the electrolysis of a copper electrolyte while disposing an insoluble electrode facing to this buffed matte surface to face. This nodular forming treatment is consisted of a series of plating treatments, i.e. a burned plating, a covering plating and a whiskery plating, each being performed under the following electrolysis conditions.

(1) Burned plating

This burned plating is performed by disposing an insoluble electrode facing to the matte side of an electrolytic copper foil to face and under the following electrolysis conditions.

Concentration of copper: 5 to 30 g/L
Concentration of sulfuric acid: 50 to 150 g/L
Temperature of plating bath: 20 to 30°C
Current density: 20 to 40 A/dm$^2$
Time: 5 to 15 seconds

Under these electrolysis conditions, a granular copper electrodeposit layer or so-called a burned plating is formed on the matte side of the electrolytic copper foil.

(2) Covering plating

Then, the surface which has been treated with this burned plating is further subjected to a covering plating under the following electrolysis conditions.

Concentration of copper: 40 to 80 g/L
Concentration of sulfuric acid: 50 to 150 g/L
Temperature of plating bath: 45 to 55°C
Current density: 20 to 40 A/dm$^2$
Time: 5 to 15 seconds

Under these electrolysis conditions, a coating of copper or so-called a covering plating is formed on the aforementioned granular copper electrodeposit layer.

(3) Whiskery plating

Furthermore, the surface which has been treated with this covering plating is further subjected to a whiskery plating under the following electrolysis conditions.

Concentration of copper: 5 to 30 g/L
Concentration of sulfuric acid: 30 to 60 g/L
Temperature of plating bath: 20 to 30°C
Current density: 10 to 40 A/dm$^2$
Time: 5 to 15 seconds

Under these electrolysis conditions, a whiskery-like copper or so-called whiskery plating is formed on the aforementioned copper coating.
The surface roughness after this nodular forming treatment of the matte side of the copper foil would be in the range of from 1.5 to 2.0μm based on Rz. If the surface roughness based on Rz of the copper foil is less than 1.5μm, it may be difficult to expect a sufficient peel strength when a wiring circuit is formed by making use of such a copper foil adhered in advance onto a substrate. On the other hand, if the surface roughness based on Rz of the copper foil exceeds over 2.0μm, nodules of relatively large size may be caused to grow locally, thereby deteriorating the etching property, high frequency characteristic and insulation reliability of the copper foil.
After being subjected to nodular forming treatment as mentioned above, the electrolytic copper foil is then subjected to a corrosion prevention treatment. The conditions for this corrosion prevention treatment may be the same as those generally employed in the art.
For example, this corrosion prevention treatment may be performed by plating zinc on the surface of the copper foil which has been subjected in advance to the aforementioned nodular forming treatment, and then subjecting this zinc-plated surface to an electrolytic chromate treatment, which is followed by a silane coupling treatment as explained below.

In the zinc-plating treatment, an electrolytic solution containing zinc at a concentration of 5 g/L and sulfuric acid at a concentration of 50 g/L and kept at a temperature of 25°C is employed, and the plating is performed at current density of 5 A/dm$^2$ for 8 seconds.

Then, the electrolytic chromate treatment on this zinc-plated surface is performed using an electrolytic solution containing chromic anhydride at a concentration of 2 g/L, the pH thereof being adjusted to 4, for 8 seconds under the condition that the current density is controlled to 1 A/dm$^2$.

Finally, g-glycidoxypropyltrimethoxy silane as a silane coupling agent is coated on this chromate-treated surface.

The electrolytic copper foil obtained after these surface treatments is superimposed on one surface of a resin substrate made for instance of fiberglass epoxy composite or polyimide by means of a thermal press-bonding or a pressure bonding with this buffed surface of the copper foil being faced to the resin substrate, thereby obtaining a copper clad laminate board.

A dry film is then superimposed on this copper clad laminate board according to a known method, and exposed, via a pattern film bearing a predetermined resist width and a circuit interval, to a UV light, thereby forming a circuit pattern. The circuit pattern formed in this manner is then subjected to an etching treatment by way of known process using a copper chloride etching solution which is available in the market, thereby obtaining a printed wiring board bearing a desired wiring pattern.

This invention is featured as mentioned above in that the matte side of an electrodeposited copper foil is at first polished with a buff so as to completely vanish the original profile of the matte surface and at the same time to form a new fine streaks surface having a roughness of 1.5μm or less, and then nodules formed of uniform fine granular copper electrodeposits are densely formed on the matte surface. Therefore, it has become possible according to this invention to obtain an electrolytic copper foil suited for use in the formation of an ultra-fine pattern, which is excellent in insulation reliability between lines of circuit pattern. Moreover, since the roughness of both surfaces of the electrolytic copper foil according to this invention is relatively low, it is possible to manufacture an electrolytic copper foil suited for use in the formation of an ultra-fine pattern, which is excellent in insulation reliability between layers and in high-frequency characteristics even if the electrolytic copper foil is applied for the manufacture of a printed wiring board.

## DESCRIPTION OF THE PREFERRED EMBODIMENTS

This invention will be further explained with reference to specific Example and Comparative Examples.

Example 1

The matte side of an electrolytic copper foil with 18μm in thickness, 1.60μm in roughness (Rz) at the shiny side thereof, 2.50μm in roughness (Rz) at the matte side thereof was subjected to a buffing treatment using a buff of #1,000 (Tsunoda Brush Kabushiki Kaisha) wherein aluminum oxide is employed as an abrasive material under the conditions of: 200 rpm in number of revolutions, 1.0 kgf/cm$^2$ in contacting pressure and 3 m/min in line speed. As a result, the surface roughness (Rz) of matte surface side of the copper foil after buffing was found to be 1.50μm.

Then, an electrolytic solution containing copper at a concentration of 12 g/L and sulfuric acid at a concentration of 100 g/L and kept at a temperature of 25°C was employed for performing a burned plating, through electrolysis, of the buff- treated surface for 10 seconds at a current density of 30 A/dm$^2$ while disposing an insoluble electrode facing to the buff-treated surface side. Thereafter, a covering plating was performed for 10 seconds at a current density of 30 A/dm$^2$ using an electrolytic solution containing copper at a concentration of 60 g/L and sulfuric acid at a concentration of 100 g/L and kept at a temperature of 50°C.

Furthermore, a whiskery plating was performed for 10 seconds at a current density of 10 A/dm$^2$ using an electrolytic solution containing copper at a concentration of 12 g/L and sulfuric acid at a concentration of 45 g/L and kept at a temperature of 25°C, thereby forming a granular copper layer.

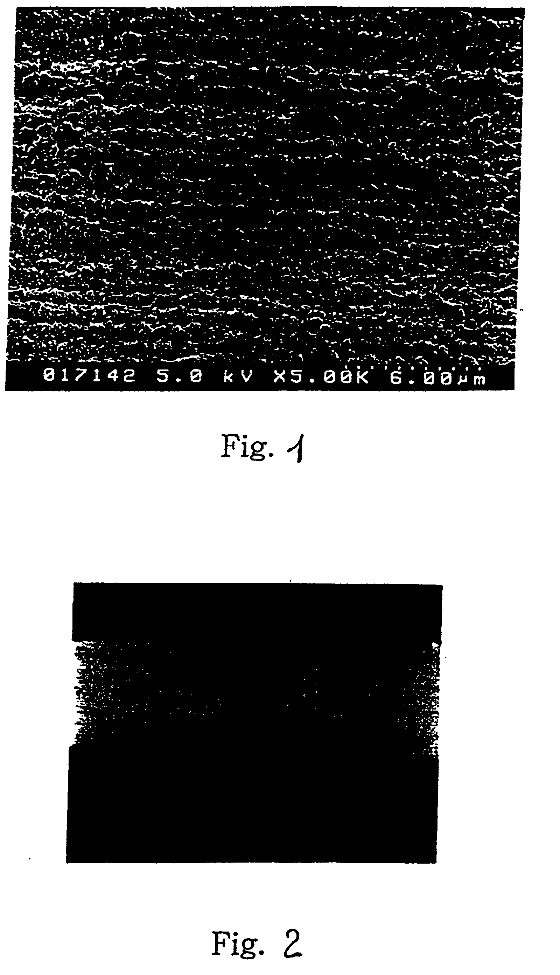

The surface roughness (Rz) of the matte surface of the copper foil after the buffing treatment was found to be 1.89μm. FIG. 1 shows a microscopic photograph (5,000 times in magnification) of the matte surface of the electrolytic copper foil after the aforementioned buffing treatment. As seen from the microscopic photograph shown in FIG. 1, nodules formed of granular copper were electrodeposited along the fine concave/convex shape of the buff-treated surface.

Then, a corrosion prevention treatment was performed as follows on the matte surface side of the electrolytic copper foil which had been subjected to the aforementioned nodular forming treatment.

First of all, a zinc-plating was performed for 8 seconds at a current density of 5 A/dm$^2$ using an electrolytic solution containing zinc at a concentration of 5 g/L and sulfuric acid at a concentration of 50 g/L and kept at a temperature of 25°C. Thereafter, an electrolytic chromating treatment was performed for 5 seconds at a current density of 1 A/dm$^2$ using an electrolytic solution containing chromic anhydride at a concentration of 2 g/L and adjusted in pH to 4. Subsequently, the resultant product was washed with running water and dried with hot air.

The electrolytic copper foil obtained after these surface treatments was superimposed on one surface of a resin substrate made of fiberglass epoxy composite (FR-4) by means of a thermal press-bonding with this buffed surface of the copper foil being faced to the resin substrate, thereby obtaining a copper clad laminate board.

Then, a dry film (Nichigo Alfa Kabushiki Kaisha) was then superimposed on this copper clad laminate board, and exposed, via a pattern film bearing a resist width of 50μm and a circuit interval of 100μm, to a UV light, thereby forming a circuit pattern. The circuit pattern formed in this manner was then subjected to an etching at a temperature of 50°C for 30 seconds by using a copper chloride etching solution which is available in the market, thereby obtaining a printed wiring board bearing a desired wiring pattern.

Then, the following evaluation tests were conducted on this printed wiring board.

(1) The size of copper grains embedded in the fiberglass epoxy composite substrate:

A piece of the printed wiring board was embedded in a cold embedding resin and kept for a whole day and night so as to allow the resin to be completely cured. Thereafter, a photograph of 1,500 times in magnification of the cross-section of the circuit pattern in the longitudinal direction thereof was taken by making use of a microscope (FIG. 2).

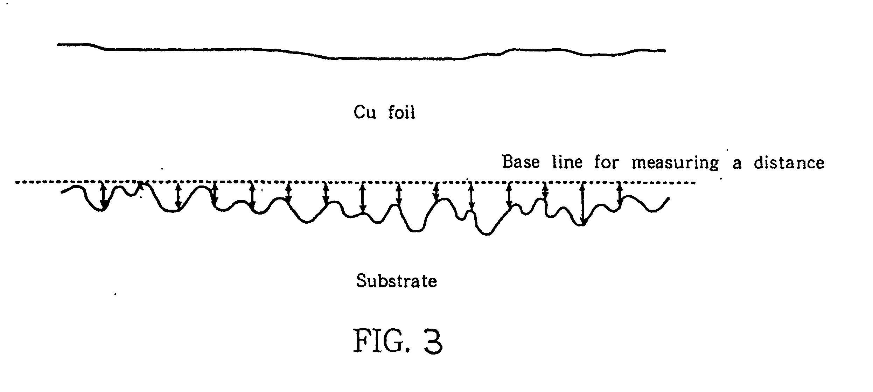

Then, a straight line was drawn as shown in FIG. 3 and the distance from this straight line to the copper grain was measured at 15 measuring points. Then, an average value and standard deviation of the measured distances were calculated. This standard deviation of the measured distances is indicative of the non-uniformity in size of copper grains, i.e. the smaller this standard deviation is, the smaller the non-uniformity in size of the copper grains.

The average value obtained was 0.48 and the standard deviation obtained was 0.43.

(2) Etching factor:

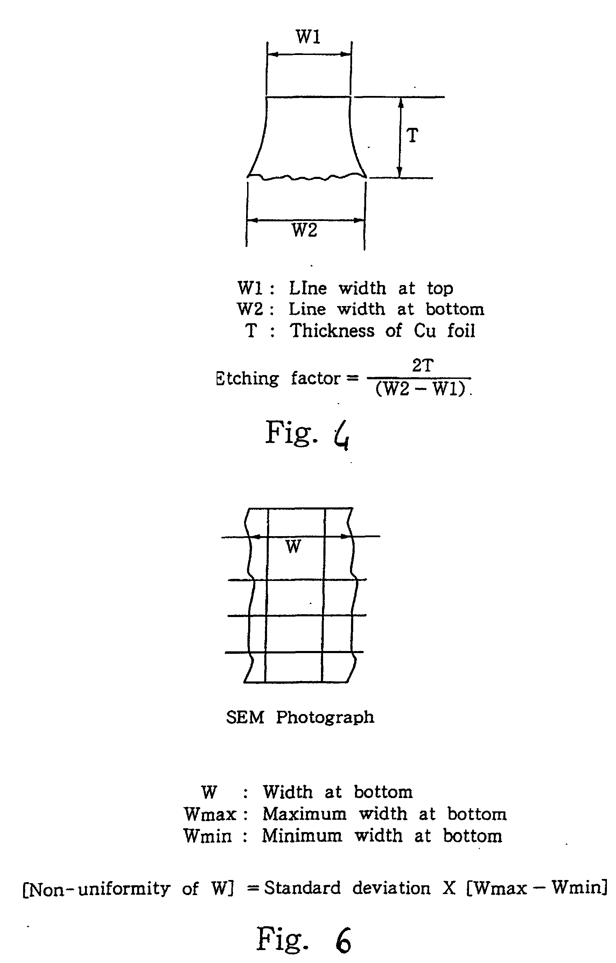

The etching factor was calculated as follows by referring to the microscopic photograph of 600 times in magnification of a piece of the same cross-section as explained in the above item (1). Namely, as shown in FIG. 4, the top width of the wiring pattern of the printed wiring board was defined as W1, the bottom width of the wiring pattern of the printed wiring board was defined as W2 and the thickness of the copper foil was defined as T in the calculation of the etching factor Ef according to the following equation.

$$Ef = 2T/(W2 - W1)$$

It can be understood from this equation that the section of the circuit pattern becomes more close to a square in shape, i.e. more sharp in shape, the etching factor becomes larger in value. The etching factor obtained in Example 1 was 3.69 in average of six sectional pieces.

(3) Linearity of wiring pattern:

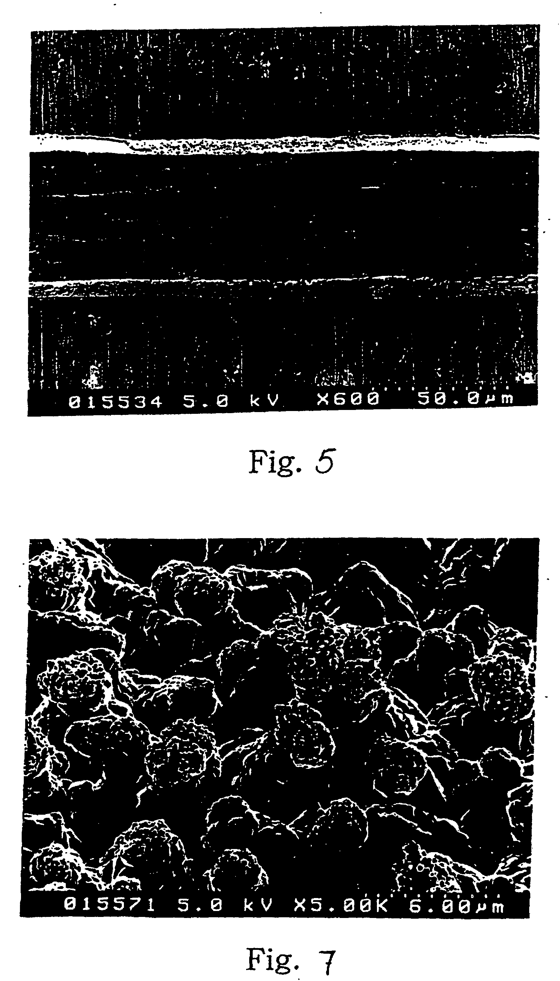

A fiberglass epoxy composite substrate was press-bonded onto the buff-treated surface of the electrolytic copper foil obtained in Example 1 to manufacture a circuit pattern having a line width of 50 to 100μm. This circuit pattern was then mounted on a sample table of an electron microscope and the microscopic photograph of 600 times in magnification of the circuit pattern (FIG. 5) was taken by making use of a field emission type electron microscope (Hitachi Seisakusho, S-4100). Since both surfaces of electrolytic copper foil obtained according to this invention was low in roughness, the linearity of the circuit was excellent. In this invention, the phenomenon that the quality of etching characteristics can be manifested by the features of the irregularity at the bottom line of the circuit was taken notice of, and therefore the etching characteristics was evaluated from the degree of irregularity as explained below.

Then, a pair of parallel straight lines were drawn in the longitudinal direction of the circuit line as shown in FIG. 6 and then the width of the bottom of the circuit was measured at 15 measuring points which were set apart equidistantly. Then, an average value and standard deviation of-the measured widths were calculated. This standard deviation of the measured widths is indicative of the degree of linearity at the bottom of the circuit, i.e. the smaller this standard deviation is, the smaller the non-uniformity in width of the circuit, which means in turn that the trace of etching is more close to a straight line. As a matter of fact, the standard deviation in width of the circuit according to this invention was found to be 0.67μm, indicating an excellent linearity of the circuit. Therefore, the remnant of copper at the bottom of the circuit after etching treatment is very little in the circuit pattern of this invention, so that it is possible to obtain an excellent inter-circuit insulation.

(4) Peel strength:

The peel strength of a wiring pattern with 10mm in line width was measured. As a result, the peel strength of the wiring pattern was found to be 1.02 kgf/cm.

The results of these evaluation tests are summarized in Table 1.

Comparative Example 1

A granular copper layer was deposited on the matte surface side of an electrolytic copper foil with 18μm in thickness, 1.60μm in roughness (Rz) at the shiny side thereof, 4.60μm in roughness (Rz) at the matte surface side thereof in the same conditions as explained in Example 1, but without performing the aforementioned buffing treatment. The surface roughness of the resultant matte surface side of the copper foil was found to be 5.75μm. FIG. 7 shows a microscopic photograph (5,000 times in magnification) of the matte surface side of the electrolytic copper foil after the deposition of the granular copper.layer. As seen from FIG. 7, nodules formed of granular copper were irregularly electrodeposited on the matte surface side of the copper foil.

Then, a corrosion prevention treatment was performed on the matte surface side of the electrolytic copper foil bearing such a granular copper layer as explained above under the same conditions as in Example 1.

The electrolytic copper foil obtained after these surface treatments was superimposed on one surface of a resin substrate made of fiberglass epoxy composite by means of a thermal press-bonding with this surface-treated side of the copper foil being faced to the resin substrate, thereby obtaining a copper clad laminate board.

Then, this copper clad laminate board was exposed, via a pattern film bearing a resist width of 50μm and a circuit interval of 100μm, to a UV light in the same manner as in Example 1, thereby forming a circuit pattern. The circuit pattern formed in this manner was then subjected to an etching to obtain a printed wiring board.

Then, the evaluation tests were conducted on this printed wiring board in the same manner as in Example 1.

The size of copper grains embedded in the fiberglass epoxy composite substrate was found to be 2.01 in average and the standard deviation was 1.67.

The etching factor was found to be 1.86 in average of six sectional pieces.

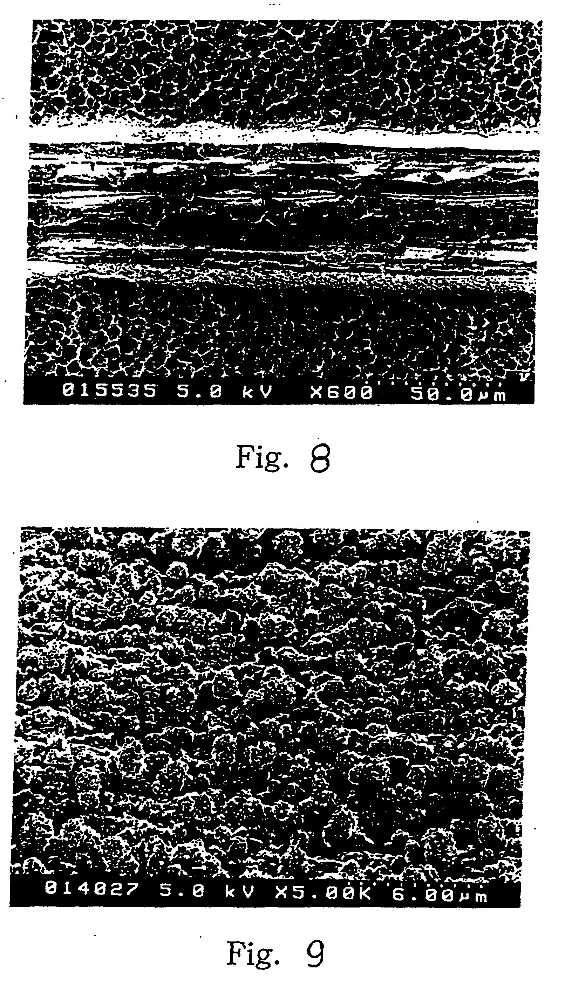

Then, a fiberglass epoxy composite substrate was press-bonded onto the treated surface of the electrolytic copper foil in the same manner as in Example 1 to manufacture a circuit pattern having a line width of 50 to 100μm. Thereafter, the microscopic photograph of 600 times in magnification of this circuit pattern (FIG. 8 ) was taken in the same manner as in Example 1. As apparent from the microscopic photograph, since the matte surface side of electrolytic copper foil according to this Comparative Example 1 were high in roughness, the linearity of the circuit was poor.

Then, a pair of parallel straight lines were drawn in the longitudinal direction of the circuit line in the same manner as in Example 1, and then the width of the bottom of the circuit was measured at 15 measuring points which were set apart equidistantly. Then, an average value and standard deviation of the measured widths were calculated.

The peel strength of a wiring pattern with 10mm in line width was found to be 1.51 kgf/cm.

The results of these evaluation tests such as the roughness of the matte surface side, etching factor and linearity of circuit are summarized in Table 1.

Comparative Example 2

A granular copper layer was deposited on the shiny side of the same electrolytic copper foil as employed in Example 1, i.e. 18μm in thickness, 1.60μm in roughness (Rz) at the shiny surface thereof, 2.50μm in roughness (Rz) at the matte surface side thereof in the same conditions as explained in Example 1, but without performing the aforementioned buffing treatment. The surface roughness of the resultant shiny surface of the copper foil was found to be 2.09μm. FIG. 9 shows a microscopic photograph (5,000 times in magnification) of the shiny side of the electrolytic copper foil after the deposition of the granular copper layer. As seen from FIG. 9, nodules formed of granular copper were irregularly electrodeposited on the shiny side of the copper foil.

Then, a corrosion prevention treatment was performed on the shiny side of the'electrolytic copper foil bearing such a granular copper layer as explained above under the same conditions as in Example 1.

Then, this electrolytic copper foil bearing a granular copper layer formed on the shiny surface thereof was exposed, via a pattern film bearing a resist width of 50μm and a circuit interval of 100μm, to a UV light in the same manner as in Example 1, thereby forming a circuit pattern. The circuit pattern formed in this manner was then subjected to an etching to obtain a printed wiring board.

Then, the evaluation tests were conducted on this printed wiring board in the same manner as in Example 1.

The size of copper grains embedded in the fiberglass epoxy composite substrate was found to be 0.98 in average and the standard deviation was 0.871.

The etching factor was found to be 2.22 in average of six sectional pieces.

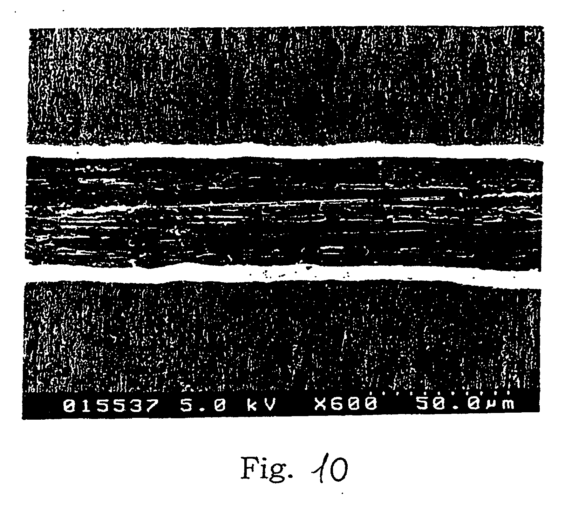

Then, a fiberglass epoxy composite substrate was press-bonded onto the treated surface of the electrolytic copper foil in the same manner as in Example 1 to manufacture a circuit pattern having a line width of from 50 to 100μm. Thereafter, the microscopic photograph of 600 times in magnification of this circuit pattern (FIG. 10) was taken in the same manner as in Example 1. As apparent from the microscopic photograph, since the linearity of the circuit was not sufficient enough for use in the formation of an ultra-fine pattern.

Then, a pair of parallel straight lines were drawn in the longitudinal direction of the circuit line in the same manner as-in Example 1, and then the width . of the bottom of the circuit was measured at 15 measuring points which were set apart equidistantly. Then, an average value and standard deviation of the measured widths were calculated.

The peel strength of a wiring pattern with 10mm in line width was found to be 1.13 kgf/cm.

The results of these evaluation tests such as the roughness of the matte surface side, etching factor and linearity of circuit are summarized in Table 1.

## T a b l e 1

| | Example 1 | Comparative Example 1 | Comparative Example 2 (e) |
|---|---|---|---|
| Average surface roughness before treatment [RZ]($\mu$m) (a) | 2.50 | 4.60 | 1.60 (Shiny surface side) |
| Average surface roughness after treatment [RZ]($\mu$m) (a) | 1.50 | | |
| Average surface roughness after deposition of granular copper layer [RZ]($\mu$m) (a) | 1.89 | 5.75 | 2.09 |
| Diameter of granular Cu — Average ($\mu$m) (b) | 0.97 | 1.62 | 1.34 |
| Diameter of granular Cu — Standard deviation ($\mu$m) (b) | 0.113 | 0.49 | 0.276 |
| Depth of Cu grains embedded in substrate — Average ($\mu$m) c) | 0.48 | 2.01 | 0.98 |
| Depth of Cu grains embedded in substrate — Standard deviation ($\mu$m) (c) | 0.430 | 1.67 | 0.781 |
| Circuit width (bottom) — Average ($\mu$m) (d) | 50.8 | 63.5 | 68.3 |
| Circuit width (bottom) — Standard deviation ($\mu$m) (d) | 0.67 | 2.89 | 1.02 |
| Etching factor | 3.69 | 1.86 | 2.22 |
| Peel strength (kgf/cm) | 1.02 | 1.51 | 1.13 |
| Insulation reliability — Interlayer insulation | Very good | Bad | Good |
| Insulation reliability — Intercircuit insulation | Very good | Bad | Good |

Note:
(a) An average value of three measuring points as measured with a surface roughness tester.
(b) An average value and standard deviation of copper grains, which were obtained as the diameter of the copper grains were measured at ten points at random from a microscopic photograph (5,000 times in magnification) of the matte side of the copper foil.
(c) An average value and standard deviation of the depth of nodules, which were obtained as the fiberglass epoxy composite substrate was pressure-bonded onto the matte side of the copper foil, and the depth of nodules embedded in the substrate was measured at 15 measuring points.
(d) An average value and standard deviation of the width of circuit, which were obtained as the fiberglass epoxy composite substrate was pressure-bonded onto the buff-treated surface side of the copper foil, and a circuit having a line width of 50 to 100µm was formed on the copper foil, which was then measured at 15 measuring points.
(e) All values indicated in the column of Comparative Example 2 were obtained by measuring the features of the shiny surface side.

EP 0 785 295 B1

**Claims**

1. An electrolytic copper foil in which an original profile of a matte surface thereof has been completely extinguished and fine ruggednesses having buffed streaks have been newly formed thereon, **characterized in that** a surface roughness Rz of the matte surface before forming a nodular layer is 1.5µm or less and the surface roughness thereof after forming said nodular layer is 1.5 to 2.0µm.

2. The electrolytic copper foil according to claim 1, wherein a corrosion prevention layer is provided on said nodular layer.

3. The electrolytic copper foil according to claim 2, wherein said corrosion prevention layer is composed of a zinc layer and a chromate-treatment layer formed on said zinc layer.

4. The electrolytic copper foil according to claim 3, wherein a silane coupling layer is formed on said chromate-treatment layer.

5. A method for manufacturing an electrolytic copper foil for use in a manufacture of a printed wiring board, which comprises the steps of

   buffing a matte surface of the electrolytic copper foil to completely extinguish an original profile of the matte surface,
   further buffing the completely extinguished matte surface to newly form fine ruggednesses having buffed streaks and to controll a surface roughness of the matte surface before forming nodules thereon to 1.5µm or less, and
   subjecting said matte surface to a nodular forming treatment to control the surface roughness to 1.5 to 2.0µm after said nodular forming treatment.

**Patentansprüche**

1. Eine elektrolytische Kupferfolie, in welcher ein ursprüngliches Profil einer matten Oberfläche davon vollständig beseitigt worden ist und feine Rauheiten mit polierten Streifen darauf neu gebildet worden sind, **dadurch gekennzeichnet, dass** eine Oberflächenrauigkeit Rz der matten Oberfläche vor der Bildung einer knollenförmigen Schicht 1,5 um oder kleiner ist und die Oberflächenrauigkeit davon nach der Bildung der knollenförmigen Schicht 1,5 bis 2,0 µm ist.

2. Die elektrolytische Kupferfolie gemäß Anspruch 1, worin eine Korrosionsschutzschicht auf der knollenförmigen Schicht bereitgestellt wird.

3. Die elektrolytische Kupferfolie gemäß Anspruch 2, worin die Korrosionsschutzschicht zusammengesetzt ist aus einer Zinkschicht und einer Chromatierschicht, die auf der Zinkschicht ausgebildet ist.

4. Die elektrolytische Kupferfolie gemäß Anspruch 3, worin eine Silankopplungsschicht auf der Chromatierschicht ausgebildet ist.

5. Ein Verfahren zur Herstellung einer elektrolytischen Kupferfolie zur Verwendung in einer Fertigung einer gedruckten Verdrahtungsplatte, welches die folgenden Schritte umfasst:

   Polieren einer matten Oberfläche der elektrolytischen Kupferfolie, um ein ursprüngliches Profil auf der matten Oberfläche vollständig zu beseitigen,
   weiter Polieren der vollständig beseitigten matten Oberfläche, um feine Rauheiten mit polierten Streifen neu zu bilden und um eine Oberflächenrauigkeit der matten Oberfläche vor der Bildung von Knollen darauf auf 1,5 µm oder weniger zu regulieren, und
   Unterwerfen dieser matten Oberfläche einer Knollenbildungsbehandlung, um die Oberflächenrauigkeit auf 1,5 bis 2,0 µm nach dieser Knollenbildungsbehandlung zu regulieren.

**Revendications**

1.  Feuille de cuivre électrolytique, dans laquelle un profil original d'une surface de matte de celle-ci a été complètement éliminé et de fines aspérités ayant des stries polies ont été nouvellement formées sur celle-ci, **caractérisée en ce que** la rugosité de surface (Rz) de la surface de matte avant de former une couche nodulaire est de 1,5 μm ou moins et la rugosité de surface de celle-ci après avoir formé ladite couche nodulaire est de 1,5 à 2,0μm.

2.  Couche de cuivre électrolytique selon la revendication 1, dans laquelle une couche empêchant la corrosion est prévue sur ladite couche nodulaire.

3.  Feuille de cuivre électrolytique selon la revendication 2, dans laquelle ladite couche empêchant la corrosion est constituée d'une couche de zinc et d'une couche de traitement au chromate formée sur ladite couche de zinc.

4.  Feuille de cuivre électrolytique selon la revendication 3, dans laquelle une couche de couplage au silane est formée sur ladite couche de traitement au chromate.

5.  Procédé pour fabriquer une feuille de cuivre électrolytique utilisable dans la fabrication d'un circuit imprimé, qui comprend les étapes de :

    -   polir une surface de matte de la feuille de cuivre électrolytique pour éliminer complètement un profil original de la surface de matte,
    -   polir encore la surface de matte complètement éliminée pour former nouvellement de fines aspérités ayant des stries polies et pour contrôler la rugosité de surface de la surface de matte avant de former des nodules sur celle-ci à 1,5 μm ou moins, et
    -   soumettre ladite surface de matte à un traitement formant des nodules pour contrôler la rugosité de surface à 1,5 à 2,0 μm après ledit traitement formant des nodules.

Fig. 1

Fig. 2

Cu foil

Base line for measuring a distance

Substrate

FIG. 3

EP 0 785 295 B1

W1

T

W2

W1 : LIne width at top
W2 : Line width at bottom
T : Thickness of Cu foil

$$\text{Etching factor} = \frac{2T}{(W2 - W1)}$$

## Fig. 4

W

SEM Photograph

W : Width at bottom
Wmax : Maximum width at bottom
Wmin : Minimum width at bottom

[Non-uniformity of W] = Standard deviation X [Wmax − Wmin]

## Fig. 6

Fig. 5

Fig. 7

**Fig. 8**

**Fig. 9**

015537 5.0 kV X600 50.0μm

Fig. 10